# EUROPÄISCHE PATENTANMELDUNG

(11) **EP 1 138 804 A2**
(43) Veröffentlichungstag der Anmeldung: **04.10.2001**
(21) Anmeldenummer: 01107282.4
(22) Anmeldetag: 23.03.2001
(51) Int. Cl.: C23C 28/04

(54) **Bauelement mit zumindest zwei aneinander grenzenden Isolierschichten und Herstellungsverfahren dazu**

(30) Priorität: 27.03.2000 DE 10015215
(71) Anmelder: Infineon Technologies AG, 81669 München (DE)
(72) Erfinder: Lowack, Klaus, Dr., 91054 Erlangen (DE); Schmid, Guenter, Dr., 91334 Hemhofen (DE); Sezi, Recai, Dr., 91341 Roettenbach (DE)
(74) Vertreter: Viering, Hans-Martin, Dipl.-Ing.

(57) **Zusammenfassung**

Die Erfindung betrifft ein Bauelement mit zwei aneinander grenzenden Isolierschichten und ein Herstellungsverfahren dazu. Das Bauelement hat eine aktivierte Isolierschicht, die durch Metallisierung zu einer elektrisch leitenden Schicht umgewandelt werden kann.

## Beschreibung

Die Erfindung betrifft ein Bauelement mit zumindest zwei aneinander grenzenden Isolierschichten und ein Herstellungsverfahren dazu.

Bei elektronischen und mikroelektronischen Bauelementen werden benachbarte elektrische Leiterbahnen mit einem Isolator (Isolierschicht) voneinander getrennt. Zur Isolierung der nebeneinander oder übereinanderliegenden Leiterbahnen wird insbesondere bei einer integrierten Schaltung (integrated Circuit IC) oder einem Multichip-Modul (MCM) ein hochtemperaturstabiles organisches oder anorganisches Material verwendet. Dabei werden Materialien wie z.B. Polyimid, Benzocyclobuten, Polybenzoxazol und/oder Siliziumdioxid verwendet. Die Auswahl des Materials richtet sich auch danach, welche physikalische Eigenschaft des Isolators (low-stress-Verhalten; Photosensitivität; Wasserdampfdurchlässigkeit; Sauerstoffdurchlässigkeit; Metalldiffusionsfähigkeit etc.) zur Geltung kommen soll, weil die einsetzbaren Materialien unterschiedliche physikalische Eigenschaftsprofile haben.

Die Kompensation der physikalischen Schwächen des ausgewählten Isolationsmaterials erfolgt entweder gar nicht oder durch eine zusätzliche Abdeckung (z.B. zur Verringerung der Wasserdampfdurchlässigkeit), eine Substratrückseitenbeschichtung (z.B. zur Erniedrigung stressbedingter Substratverbiegung) oder eine andere Hilfskonstruktion.

Aufgabe der vorliegenden Erfindung ist es, ein Bauelement zu schaffen, das zumindest zwei Isolierschichten umfasst, wobei die physikalischen Schwächen einer Isolierschicht durch die nachfolgende Isolierschicht kompensiert werden können. Ausserdem ist Gegenstand der Erfindung ein Verfahren zur Herstellung eines solchen Bauelements

Lösung der Aufgabe und Gegenstand der Erfindung ist ein Bauelement, das ein Substrat und mindestens eine obere und eine untere Isolierschicht umfasst, die aneinandergrenzen und deren Schichtdicke im Bereich zwischen 0,05 und 50 µm liegt, wobei mindestens ein Bereich der einen Isolierschicht für eine nachfolgende Metallisierung, eine Photosensibilisierung, eine Hydrophobierung und/oder eine andere Oberflächenfunktionalisierung aktiviert ist.

Ausserdem ist Gegenstand der Erfindung ein Verfahren zur Herstellung eines Bauelements, wobei in einem ersten Arbeitsschritt eine untere Isolierschicht auf ein Substrat aufgebracht und ggf. strukturiert wird, in einem zweiten Arbeitsschritt zumindest ein Bereich der unteren Isolierschicht aktiviert und in einem dritten Arbeitsschritt zumindest eine zweite, obere Isolierschicht auf die untere, aktivierte Isolierschicht aufgebracht und strukturiert wird.

Schließlich ist Gegenstand der Erfindung ein Verfahren zur Herstellung eines Bauelements, wobei in einem ersten Arbeitsschritt eine Isolierschicht auf ein Substrat aufgebracht und ggf. strukturiert wird, in einem zweiten Arbeitsschritt eine weitere Isolierschicht aufgebracht und strukturiert wird und in einem dritten Arbeitsschritt eine der beiden Isolierschichten aktiviert wird.

Das Bauelement ist bevorzugt ein elektronisches oder mikroelektronisches Bauelement. Es hat, wiederum bevorzugt, zwei Isolationsschichten, die chemisch unterschiedlich sind und entsprechend auch verschiedene physikalische Eigenschaftsprofile haben. So hat die erste Schicht beispielsweise zwar ein gutes low-stress-Verhalten, aber eine zu hohe Wasserdurchlässigkeit und die zweite Schicht ist wasserundurchlassig, so dass die Durchlässigkeit der ersten Isolationsschicht kompensiert wird. Eine Schicht ist die aktivierte, die im weiteren Verlauf z.B. des Wafer-Herstellungsprozesses durch Bekeimung mit einer Keimlösung und nachfolgende Metallisierung die
elektrisch leitende Schicht ergeben soll. Trotz der Metallisierung oder einer anderen nachfolgenden Bearbeitung behält die zunächst aktivierte Isolationsschicht ihre erwünschten physikalischen Eigenschaften wie z.B. Wasserundurchlässigkeit bei.

Die Anzahl der übereinander liegenden Schichten ist keineswegs auf zwei beschränkt, sondern vielmehr beliebig, je nach Bauelement, wobei auch zwei gleichartige Schichten übereinander liegen können, wenn die untere Schicht vor dem Aufbringen der oberen Schicht aktiviert wird.

Als vorteilhaft hat es sich erwiesen, wenn die obere Isolierschicht bei der Aktivierung der unteren Isolierschicht als Maske dient. Dazu muss im Verfahren vor der Aktivierung die Strukturierung der oberen Isolierschicht erfolgen. Durch Belichten, Entwickeln, Trocknen und/oder Ausheizen kann die obere, bevorzugt photosensitive Isolierschicht strukturiert werden. Wenn die obere Isolierschicht nicht photosensitiv ist, dann kann durch herkömmliches Beschichten mit Photolack und dessen Strukturierung und Rückätzen der oberen Isolierschicht die Maske erzeugt werden.

Nach einer anderen Ausführungsform wird die untere Isolierschicht vor der Aufbringung der oberen Isolierschicht aktiviert.

Welche der beiden Schichten aktiviert wird, richtet sich erstens danach, ob der jeweilige Aktivator durch seine Bestandteile nur mit einer Schicht abreagiert und, falls der Aktivator potentiell beide Schichten aktivieren könnte, wann der Aktivator angewendet wird, d.h. auf welche Oberfläche er trifft.

Unter dem Begriff "Isolierschicht oder Isolationsschicht" versteht man hier ein elektrisch isolierendes Material, das nach der Fertigstellung des Bauelements in diesem Bauelement verbleibt, d.h. nicht entfernt wird. Materialien, die als Strukturierungshilfsmittel dienen und nach der Durchführung eines Prozesses (z.B. Metallisierung, Ätzung) wieder entfernt werden, wie z.B. kommerzielle Photolacke auf Novolak-Basis, sind darunter nicht zu verstehen. Ebenso sind Materialien, die ein Bestandteil des Substrates sind (z.B. Leiterplatten auf Epoxidharzbasis) oder als Abdeckung verwendet werden (z.B. Passivierungsschicht auf einem IC aus Siliziumoxid und/oder -nitrid oder IC-Gehäuse aus gefülltem Epoxidharz, d.h. Pressmasse, "mold compound") keine "Isolierschichten" im Sinne des hier gebrauchten Begriffs.

Die Dicke der Isolierschicht ist vorzugsweise zwischen 0,05 und 50 µm, besonders bevorzugt zwischen 0,1 und 20 µm.

Die Isolierschicht besteht bevorzugt aus einem Polymer. Das Polymer weist vorteilhaft eine hohe chemische und thermische Beständigkeit auf. Hierdurch werden Löt- und Reinigungsprozesse sowie die Aktivierung (chemisch und/oder physikalisch) unbeschadet überstanden. Vorteilhaft hat sich insbesondere der Einsatz folgender Arten von Polymeren erwiesen: Dielektrika wie Polyimide (wie z.B. aus der US 3,957,512 und aus der EP 0 027 506 B1), Polybenzoxazole (wie z.B. aus der EP 0 023 662 B1 und der EP 0 264 678 B1 bekannt), Polybenzimidazole; vorwiegend aromatische Polyether, Polyetherketone,
Polyethersulfone; Benzocyclobuten, aromatische Kohlenwasserstoffe, Polychinoline, Polychinoxaline, Polysiloxane (Silicone), Polyurethane oder Epoxidharze. Copolymere oder Mischungen dieser Polymeren untereinander sind ebenfalls geeignet. Weiterhin eignen sich Verbindungen bzw. Polymere mit organisch-anorganischer Struktur, wie z.B. Organosilizium-, Organophosphor oder Organoborverbindungen. Bekanntlich kann man alle der genannten Materialklassen entweder in fertiger Form applizieren (Schleudern, Siebdruck etc.) oder aus der Gasphase auf dem Substrat oder der ersten Isolierschicht eine Vorstufe abscheiden und dort das Polymer erzeugen. Zu den Schichten, die auf dem Substrat oder einer Isolierschicht erzeugt werden gehören z.B. Schichten aus Kohlenstoff, a-C:H
(amorph) sowie a-C:H-Schichten mit weiteren Elementen wie Si, P, O, B. Rein anorganische Materialien wie Siliziumoxid und - nitrid zählen nur dann dazu, wenn sie als die obere der beiden Schichten aufgebracht und strukturiert bzw. über eine Lochmaske, Drucktechnik und/oder Lithographie aufgebracht werden.

Prinzipiell sind alle Materialien geeignet, die bei den durchzuführenden Prozessen stabil sind, elektrisch gut isolierend wirken und auf dem fertigen Bauelement keinen Störeffekt haben. Besonders geeignet sind photosensitive Formulierungen der Isoliermaterialien.

Die Isolierschicht kann auch mehrere der oben genannten Komponenten sowie Füllstoff enthalten. Besonders für die Verwendung als Paste, aber auch für Siebdrucke, kann dem Isoliermaterial ein geeigneter Füllstoff beigemischt werden. Es kann beispielsweise in gelöster Form oder als Paste auf das Substrat aufgetragen werden. Geeignete Techniken sind z.B. Schleudern, Gießen, Dispensen, Rakeln, Tampondruck, Tintenstrahldruck und/oder Siebdruck.

Eine erste Isolierschicht wird beispielsweise mittels Schleudertechnik auf das Substrat aufgetragen und je nach Bedarf ausgehärtet, wenn dies zur Erhaltung der Endeigenschaften notwendig ist. Anschließend wird die zweite Isolationsschicht auf die erste aufgebracht und nach Bedarf getrocknet. Danach wird sie z.B. für die Strukturierung durch eine Maske belichtet, entwickelt, getrocknet und ggf. gehärtet. Die darauffolgende Behandlung des entstandenen Schicht-Sandwiches mit einem Aktivator führt zu einer selektiven Aktivierung entweder der oberen oder der unteren Isolationsschicht. Möglich ist auch, dass die zweite Isolierschicht bereits strukturiert. z.B. durch Drucken aufgebracht wird.

Als "Härtung" werden alle Prozesse bezeichnet, mit deren Hilfe lösliche in unlösliche Produkte überführt werden. Darunter fallen z.B. Ausheizen, Cyclisieren und Vernetzen.

Die Aktivierung der Oberfläche der jeweiligen Isolierschicht kann, wie im folgenden näher erläutert wird, mittels eines physikalischen Verfahrens und/ oder mittels eines chemischen Verfahrens erfolgen.

Die Aktivierung kann durch Eintauchen, Ätzen, Aussetzen, Bestrahlen, Besputtern, Erhitzen, Anlösen, Benetzen oder eine andere bekannte Technik erfolgen.

Der Aktivator ist je nach Ausführungsform ein Gas (oder eine Gasmischung), eine Flüssigkeit, eine Lösung oder ein Plasma. Der Aktivator kann insbesondere auch eine Kombination von einem Gas mit einer Flüssigkeit oder eine sonstige Kombination mehrerer Aktivatoren sein. Die Aktivierung modifiziert selektiv eine Isolierschicht oder die Oberfläche einer Isolierschicht beispielsweise in der Weise, dass später nur diese Schicht bekeimt und/oder metallisiert werden kann. Andere Aktivierungen, wie z.B. Hydrophobierung, Photosensibilisierung und/oder weitere Oberflächenfunktionalisierungen, gehören auch zu der Erfindung.

Flüssige Aktivatoren sind z.B. basische Reagenzien wie Lösungen eines oder mehrerer Alkali- und/oder Erdalkalihydroxide, Ammoniumhydroxide; oxidierende Reagenzien wie die Lösung von Wasserstoffperoxid, Chromat, Permanganat, (Per)Chlorat und/
oder Peroxosulfat; Lösungen, die eine Säure wie Schwefel-, Salz-, Salpeter- und/oder Phosphorsäure enthalten. Die genannten Lösungen können alle einzeln oder auch in beliebiger Kombination zum Einsatz kommen.

Aktivatoren, die als Plasma vorliegen sind z.B.:
Sauerstoff-, Chlor-, Kohlendioxid-, Schwefeldioxid-, Edelgas- und/oder Ammoniakplasmen; als Gase eignen sich z.B. Ozon, Sauerstoff, Halogene und/oder Schwefeldioxid sowie deren Mischungen.

Die Keimlösung ist die Lösung oder Emulsion eines Metalls (oder einer Metallverbindung) in ionogener oder kolloidaler Form. Diese Lösung kann neutral, basisch oder sauer sein. Bevorzugte Keimlösungen sind alle Lösungen von Metallen und Nichtmetallen bzw. deren Verbindungen, die die anschließende Abscheidung eines Metalls (wie z.B. Kupfer oder Nickel) katalysieren. Die Keimlösung enthält bevorzugt Edelmetalle (Ruthenium (Ru), Rhodium (Rh), Palladium (Pd), Osmium (Os), Iridium (Ir), Platin (Pt), Silber (Ag), Gold (Au)) bzw. deren Verbindungen und Komplexe (organisch und/oder anorganisch).

Das Substrat ist bevorzugt ein Halbleiter (Silizium (Si), Galiumarsenid, Germanium (Ge)) oder Keramik, wobei es unterhalb der ersten Isolierschicht schon elektronische Schaltungen incl. Metall- und Isolierschichten haben kann (z.B. ein front-end bearbeitetes Substrat). Das Substrat kann aber auch Glas, Leiterplatte und/oder Metall sein. Das Substrat kann ausserdem auch eines der oben genannten Materialien mit einer aufgebrachten Isolierschicht sein.

Das Verfahren ist insbesondere deswegen so vorteilhaft, weil viele elektronische und/oder mikroelektronische Bauelemente-vor ihrer Bearbeitung mit den mindestens zwei Isolierschichten - mit einem Buffercoating beschichtet sind (in dieser Form kommen z.B. Wafer vom Front-End-Bereich; das Buffercoating ist beispielsweise Polyimid oder
Polybenzoxazol; darunter befinden sich beispielsweise die anorganischen Passivierungsschichten Siliziumnitrid und/oder -oxid). Dieses Buffercoating kann bereits eine Isolierschicht im Sinne der Erfindung sein, d.h. sie kann nach dem Aufbringen und Strukturieren der zweiten Schicht aktiviert und entsprechend einer Ausführungsform des Verfahrens mit einer zweiten Isolierschicht beschichtet oder aktiviert werden.

Anhand von Ausführungsbeispielen soll die Erfindung noch näher erläutert werden.

### Beispiel 1

Ein handelsüblicher Wafer mit einer bereits ausgehärteten, d.h. cyclisierten und/oder ausgeheizten Polyimidbeschichtung wird wie folgt aktiviert: Das Polyimid wird durch einen kurzen Ätzschritt 25 s im Sauerstoffplasma aktiviert (500 W, 50 sccm Sauerstoff, 50 mTorr). Der aktivierte Wafer wird 10 s in deionisiertes Wasser getaucht, das Wasser abgeschleudert und der Wafer 60 s bei 120°C getrocknet. Anschließend wird eine zweite Lage eines photosensitiven Polyimids aufgeschleudert strukturiert und in einem Ofen bei 400°C unter Stickstoff ausgeheizt. Bei der Plasma-Aktivierung entsteht die aktivierte Oberfläche, auf der sich selektiv Metallkeime (z.B. ein Metallkomplex) anbinden lassen.

### Beispiel 2

Ein photosensitives Polyimid wird nach Herstellerangaben auf ein Siliziumsubstrat geschleudert, belichtet, entwickelt und ausgeheizt (siehe Beispiel 1). Für die Aktivierung des Polyimids wird das Substrat anschließend in folgende Lösungen getaucht:
- 10 min in eine 40°C warme alkalische Permanganat-Lösung, bestehend aus 140 g/l Natriumpermanganat und 50 g/l Natriumhydroxid
- Spülen in deionisiertem Wasser
- Eintauchen für 3 min bei Raumtemperatur in halbkonzentrierte Schwefelsäure (5 mol/l)
- Spülen in deionisiertem Wasser.
Danach wird eine zweite Lage Polyimid aufgeschleudert, wie oben beschrieben strukturiert und ausgehärtet (siehe Beispiel 1)

### Beispiel 3

Auf einen Siliziumwafer wird das Dielektrikum Polybenzoxazol durch Schleudertechnik aufgebracht, bei 100°C vorgetrocknet und auf einer Hotplate jeweils 1 min. bei 200°C, 260°C und 350°C unter Stickstoff ausgehärtet. Anschließend wird die Oberfläche in einem Wassergasplasma (CO:H₂ wie 1:1; 500 W, 50 sccm, 50 mTorr) aktiviert. Die aktivierte Oberfläche wird 10 s in deionisiertes Wasser getaucht, das Wasser abgeschleudert und der Wafer 60 s bei 120°C getrocknet. Danach wird eine zweite Lage Polybenzoxazol durch Siebdruck aufgebracht, vorgetrocknet und - wie oben - ausgehärtet. Bei der Plasma-Aktivierung entsteht eine carboxylgruppenhaltige Oberfläche.

### Beispiel 4

Ein photosensitives Polyimid wird auf ein Siliziumsubstrat mit einer Horizontalschleuder bei 5000 rpm aufgetragen. Die Schleuderzeit beträgt 20s. Anschließend wird der Film 3 min bei 100°C auf einer Heizplatte vorgetrocknet und dann in einem Ofen unter Stickstoffspülung 30 min bei 400°C getempert (ausgehärtet). Nach Abkühlung auf Raumtemperatur wird auf die Polyimidschicht ein photosensitives Polybenzoxazol (PBO) aufgeschleudert, auf einer Hotplate getrocknet, mit einem Belichtungsgerät über eine Maske belichtet und in einer wässrigen alkalischen Lösung entwickelt, gespült und getrocknet. Das Substrat wird auf einer Hotplate mit folgender Rampe getempert: 10°C/min bis 150°C, 5°C/min bis 280°C, Haltezeit 10 min. Danach wird auf Raumtemperatur abgekühlt. Das PBO dient als Maskierung für das Polyimid. Für die Aktivierung des Polyimids wird das Substrat anschließend für 10 min in eine 40°C warme alkalische Permanganat-Lösung, bestehend aus 140 g/l Natriumpermanganat und 50 g/l Natriumhydroxid, getaucht, mit deionisiertem Wasser gespült und dann in eine 5 mol/l Schwefelsäure für 3 min getaucht. Abschließend wird mit deionisiertem Wasser gespült.

Die Polybenzoxazolschicht dient auch dazu, dass die relativ hohe Wasserdampfdurchlässigkeit von Polyimid deutlich reduziert wird.

### Beispiel 5

Analog Beispiel 4, die Aktivierung des Polyimids erfolgt jedoch über einen kurzen Plasmaätzschritt mit Sauerstoff in einem reaktiven lonenätzer (30 sccm Sauerstoff, 500 W, 70 mTorr 10 s) mit anschließender Konditionierung 3 min in einem Konditionierbad. Dies kann z.B. eine 0,5 molare Natriumhydroxid-Lösung im Wasser sein.

### Beispiel 6

Ein photosensitives PBO wird auf ein Substrat mit einer Siliziumnitridoberfläche geschleudert und auf einer Hotplate getrocknet und anschließend auf einer Hochtemperaturheizplatte unter Stickstoff bei 350°C getempert (ausgehärtet). Nach Abkühlung auf Raumtemperatur wird ein Polyimid auf die PBO-Schicht geschleudert und auf einer Heizplatte getrocknet. Das Polyimid wird mit einem Belichtungsgerät strukturiert belichtet und entwickelt, gespült (Isopropanol, Isopropanol/
deionisiertes Wasser (1:1) und schließlich deionisiertes Wasser) anschließend getrocknet. Zum Härten des Polyimids wird das Substrat in einem Ofen unter Stickstoffspülung 60 min bei 350°C getempert. Nach Abkühlung auf Raumtemperatur wird für die Aktivierung des Polyimids das Substrat für 10 min in eine 40°C warme 1,5 Gew.-%ige Natriumhydroxid-Lösung getaucht, mit deionisiertem Wasser gespült und dann in eine 5 mol/l Schwefelsäure für 3 min getaucht.

Die Polybenzoxazolschicht zwischen Substrat und Polyimid ist vorteilhaft, da sie als Stress-Ausgleichsschicht dient und an beiden Grenzschichten besser haftet als das Polyimid auf Substrat.

### Beispiel 7

PBO wird wie in Beispiel 6 auf ein Substrat geschleudert und getempert. Auf die PBO-Schicht wird im Schablonendruckverfahren eine Cyclothene-Schicht (Benzocyclobuten, BCB) aufgetragen und 30 min bei 250°C ausgeheizt. Die Aktivierung des BCB erfolgt durch Eintauchen des Substrats in eine 1,5 %ige Natronlauge bei 40°C für 5 min.

### Beispiel 8

Ein photosensitives Polyimid wird auf ein Substrat geschleudert, danach 2 min bei 110°C getrocknet und anschließend bei 350°C 90 min getempert. Als Maskierung für die selektive Aktivierung des Polyimids und zur Verringerung dessen Gas- und Dampfdurchlässigkeit wird über eine Lochmaske mittels eines CVD(Chemical-Vapor-Deposition)-Verfahrens eine 0,5 µm dicke amorphe Kohlenwasserstoffschicht abgeschieden. Anschließend erfolgt die Aktivierung des Polyimids wie bei Beispiel 4. Die Metallisierung kann ebenfalls entsprechend Beispiel 4 durchgeführt werden.

### Beispiel 9

Ein Polyimid wird auf ein Silizium-Substrat geschleudert (20 s bei 5000 rpm), anschließend getrocknet (3 min bei 100°C auf einer Heizplatte) und 30 min auf einer Heizplatte (Hotplate) bei 350°C getempert. Nach Abkühlung auf Raumtemperatur wird ein anderes, photosensitives Polyimid aufgeschleudert, bei 90°C getrocknet, belichtet, entwickelt, gespült (Isopropanol, Isopropanol/deionisiertes Wasser (1:1) und schließlich deionisiertes Wasser) anschließend getrocknet und bei 400°C getempert. Das nicht photosensitive Polyimid, das die untere Schicht bildet, wird wie folgt aktiviert: Eintauchen (10 min) in eine 1,5 %ige 45°C warme Natriumhydroxid-Lösung, mit deionisiertem Wasser spülen und darauf folgendes Eintauchen in eine 1M HCl-Lösung bei 30°C für 30 min, erneutes Spülen mit deionisiertem Wasser.

### Beispiel 10

Ein Wafer mit einer 4 µm dicken bereits cyclisierten Polyimidschicht ("Substrat") wird wie folgt prozessiert: Auf dieses Substrat wird per CVD-Verfahren eine wasserundurchlässige Siliziumnitrid-Schicht (50 nm) aufgebracht und die Nitridschicht mit Hife eines Photolacks strukturiert (Belichtung und Entwicklung des Photolacks, Trockenchemisches Ätzen der Nitridschicht mit CHF₃/O₂, Strippen des Photolacks). Beim Plasmaätzen wird auf der darunter liegenden Polyimidlage gestoppt. Durch das Plasmaätzen entsteht eine aktivierte Oberfläche.

### Beispiel 11

Substrat analog Beispiel 10, auf dem die Siliziumoxidschicht über eine Schattenmaske bereits strukturiert, d.h. über eine Lochmaske, aufgebracht wird. Das freiliegende Polyimid wird durch Eintauchen (1min) in konzentrierte Salpetersäure bei 50°C aktiviert.

Nach der Erfindung ist es erstmals möglich, bei einem Bauelement, wie einem Wafer, mit einem Leiter/Isolator/Leiter-Schichtaufbau die physikalischen Eigenschaften zweier Isolierschichten zu kombinieren, wobei eine der Isolierschichten selektiv aktiviert ist und durch eine Metallisierung oder Ähnliches elektrisch leitend gemacht werden kann.

Beispiele für photosensitive Polyimide und Polybenzoxazole:
Polyimid: EP 0 027 506 B1
Polybenzoxazol: EP 0 023 662 B1, EP 0 264 678 B1

## Patentansprüche

1. Bauelement, das ein Substrat und mindestens eine obere und eine untere Isolierschicht umfasst, die aneinander grenzen und deren Schichtdicke im Bereich zwischen 0,05 und 50 µm liegt, wobei mindestens ein Bereich der einen Isolierschicht für eine nachfolgende Metallisierung, eine Photosensibilisierung, eine Hydrophobierung und/oder eine andere Oberflächenfunktionalisierung aktiviert ist.

2. Bauelement nach Anspruch 1, das ein elektronisches oder mikroelektronisches Bauelement ist.

3. Bauelement nach einem der vorstehenden Ansprüche, das zwei chemisch verschiedene Isolierschichten umfasst.

4. Bauelement nach einem der vorstehenden Ansprüche, bei dem eine obere Isolierschicht strukturiert und/oder die Maske für die Aktivierung der unteren Schicht ist.

5. Bauelement nach einem der vorstehenden Ansprüche, bei dem die aktivierten Bereiche bekeimt und/oder metallisiert sind.

6. Verfahren zur Herstellung eines Bauelements, wobei in einem ersten Arbeitsschritt eine untere Isolierschicht auf ein Substrat aufgebracht und ggf. strukturiert wird, in einem zweiten Arbeitsschritt zumindest ein Bereich der unteren Isolierschicht aktiviert und in einem dritten Arbeitsschritt zumindest eine zweite, obere Isolierschicht auf die untere, aktivierte Isolierschicht aufgebracht und strukturiert wird.

7. Verfahren nach Anspruch 6, bei dem zumindest eine Isolierschicht im Anschluss an ihre Auftragung strukturiert wird.

8. Verfahren zur Herstellung eines Bauelements, wobei in einem ersten Arbeitsschritt eine Isolierschicht auf ein Substrat aufgebracht und ggf. strukturiert wird, in einem zweiten Arbeitsschritt eine weitere Isolierschicht aufgebracht und strukturiert wird und in einem dritten Arbeitsschritt eine der beiden Isolierschichten aktiviert wird.

9. Verfahren nach Anspruch 8, bei dem nach dem zweiten und vor dem dritten Arbeitsschritt die zweite Isolierschicht strukturiert wird.

10. Verfahren nach einem der Ansprüche 8 oder 9, bei dem nach dem ersten Arbeitsschritt die untere Isolierschicht strukturiert wird.
